# EUROPEAN PATENT SPECIFICATION

(11) **EP 0 590 627 B1**
(45) Date of publication and mention of the grant of the patent: **03.01.2001**
(21) Application number: 93115697.0
(22) Date of filing: 29.09.1993
(51) Int. Cl.: G03F 1/14, G03F 1/00

(54) **Improved photomask for semiconductor fabrication**
Photomaske zur Herstellung von Halbleitern
Masque pour la fabrication de semi-conducteurs

(30) Priority: 29.09.1992 US 954192
(43) Date of publication of application: 06.04.1994
(73) Proprietor: TEXAS INSTRUMENTS INCORPORATED, Dallas Texas 75265 (US)
(72) Inventor: Cho, Songsu, Plano, Texas 75093 (US)
(74) Representative: Schwepfinger, Karl-Heinz, Dipl.-Ing.

(56) References cited:
- EP-A- 0 395 425
- EP-A- 0 437 376
- EP-A- 0 461 778
- US-A- 5 045 417

## Description

### TECHNICAL FIELD OF THE INVENTION

This invention relates to semiconductor circuit fabrication, and more particularly to a method of making a mask for use in lithographic semiconductor fabrication, which provides phase shift boundaries of the mask features.

### BACKGROUND OF THE INVENTION

Microcircuit fabrication requires that precisely controlled quantities of impurities be introduced into tiny regions of a silicon substrate, and subsequently interconnected. The patterns that define these regions are created by lithographic processes.

The first basic step of the lithographic process is applying a photoresist material as a thin film to the substrate, i.e., an oxide layer on silicon. The photoresist layer is then exposed through a mask, which contains dear and opaque features that define the pattern to be created on the photoresist layer. The areas in the photoresist that are exposed to the light are made either soluble or insoluble in a specific solvent known as a developer. Following development, the regions of the substrate no longer covered by the resist are removed by etching, thereby replicating the mask pattern in the oxide layer.

A recent development in lithography has been the use of phase shift masks. Instead of using a single clear edge area to bound opaque regions, a series of two clear edge areas are used. The result is a double boundary, with a first boundary zone transmitting light of one phase, and an second boundary zone transmitting light of a phase that is 180 degrees different. The result is that the edges of opaque regions are defined with an intensity curve that is much steeper than would occur at a single boundary zone of a non phase shifting mask. The boundaries having these steep intensity curves are referred to as a "high contrast boundaries". This high contrast effect can be used to make resist edges with steeper walls. The end result is shapes, such as lines and spaces, having much finer resolution than is possible with non phase shifting masks. For example, lines and spaces can be made much narrower and more dense.

A problem with the use of phase shift masks is in accurately aligning the double boundary with the edges of the opaque areas. For example, when the opaque area is a narrow line, each side of the line must have equal boundaries to obtain the desired high contrast effect. In existing phase mask fabrication, the opaque areas are typically fabricated as a first layer on a mask glass, with thicker phase shifting glass fabricated over the opaque regions such that the boundaries of the former overlap the boundaries of the latter. The need to fabricate two separate layers can easily give rise to misalignment between them.

From EP-A-0 461 778 a phase shift mask with self-aligned phase shift boundaries is known. According to one described method of producing such a mask a light shielding film is produced on the entire surface of a transparent substrate, and a photoresist pattern is produced thereon. Thereafter, the partially completed device is over-etched using that photoresist pattern as a mask to produce a light shielding film pattern having a desired width, and a transparent thin film pattern is produced at an aperture section of the light shielding film pattern, separated from the light shielding film pattern, by depositing a transparent thin film shifting the phase of the exposure light on the entire surface and carrying out lift-off.

From EP-A-0 437 376 phase shifting masks with self-aligned phase shift boundaries are known, wherein side-etching of a light shielding pattern is carried out before deposition of the phase shifting material in order to achieve self-alignment of the phase shift boundaries.

US-A-5 045 417 discloses a method of forming a phase shift mask, wherein a transparent phase shifting film is formed in such a manner that it covers a light shielding pattern along a pattern formed by magnifying or demagnifying the light shielding pattern or transmission pattern.

From EP-A-0 451 307 a phase-shift mask with self-aligned phase shift boundaries is known. During manufacture of this mask, regions of different thicknesses that are not covered by a light shielding layer are obtained by first isotropically etching the light shielding layer, and anisotropically etching the substrate thereafter. According to one embodiment, the substrate comprises two layers which are separated by an etch stop layer. During anisotropical etching of the substrate, the upper layer is etched down to the etch stop layer in respective regions.

EP-A-0 395 425 discloses a method of making a mask, which comprises the steps of forming an opaque pattern layer on a transparent layer which is transparent with respect to a light which is used for an exposure, forming a stopper layer on the opaque pattern layer, forming a phase shift layer which transmits the light on the opaque pattern layer to a predetermined thickness, so that a phase shift occurs between a phase of the light transmitted through the phase shift layer and a phase of the light transmitted through a portion of the mask having no phase shift layer, forming a resist pattern which is made of a resist material on the phase shift layer, and etching the phase shift layer using the stopper layer as an etching stopper and the resist pattern as an etching mask so that the phase shift layer remains on the stopper layer only in a vicinity of an edge portion of the opaque pattern layer in at least one part of the mask.

Other problems with existing phase shifting masks are that some are useful only as positive tone masks. Also, some are difficult to repair, especially those having the opaque areas fabricated on top of phase shifting areas.

### SUMMARY OF THE INVENTION

According to the present invention, a method as mentioned above comprises the steps defined in claim 1.

The mask is fabricated by uniformly depositing the etch stop layer over the pattern of opaque areas. The phase shift layer over the etch stop layer is etched so that material over the opaque areas as well as down along their edges is removed. This etching creates the thin zones around these edges. The non removed phase shift material defines the thick zone.

### BRIEF DESCRIPTION OF THE DRAWINGS

Figure 1 is a top plan view of a phase shift mask in accordance with the invention.

Figures 2A - 2C illustrate how the phase shift mask affects the intensity of transmitted light.

Figures 3A - 3H illustrate the process of making spaces on the mask so that the phase shift regions are self aligned with the opaque areas.

Figures 4A - 4H illustrate the process of making opaque areas on the mask so that the phase shift regions are self aligned with the opaque areas.

### DETAILED DESCRIPTION OF THE INVENTION

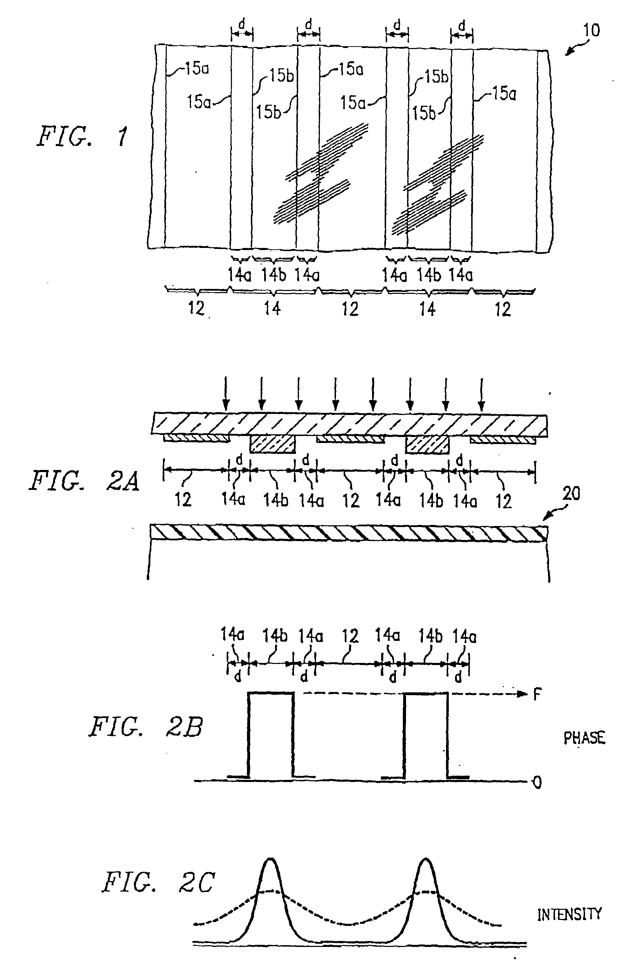

Figure 1 is a top plan view of a portion of a mask 10, such as might be used for semiconductor lithography. Mask 10 has a pattern of shapes that are either opaque or clear. For purposes of example herein, these shapes are alternating opaque lines 12 and clear spaces 14. The spaces 14 have two zones 14a and 14b, which have different thicknesses. The geometries of the shapes on mask 10 are not important to the invention, expect insofar as any edge of an opaque shape is bounded first by a clear thin zone 14a and then by a clear thick zone 14b.

More specifically, in Figure 1, the clear spaces 14 are comprised of two zones 14a and 14b made from different thicknesses of transparent material, such that they transmit light with a known phase difference. In the preferred embodiment, this phase difference is 180 degrees, which provides the maximum contrast to define the mask features.

The thin zone 14a is mask glass, covered by a clear etch stop layer (not shown). The thick zone 14b is mask glass, also covered by the etch stop layer, as well as by phase shifter material. The thin zone 14a forms a first boundary 15a with opaque area 12, and the thick zone 14b forms a second boundary 15b with the thin zone 14a. This second boundary 15b is where the phase shift of the transmitted light occurs.

The opaque areas 12 of mask 10 may be any type of known light blocking material, known in the art of photomasking. An example of a suitable material is chrome. The mask glass may be any type of known mask glass. The phase shift glass may be the same type of material as the mask glass, but with a thickness that is calculated to provide the desired phase difference.

A feature of mask 10 is that its clear zones 14a and 14b are self-aligned with respect to its opaque areas 12. Thus, the invention ensures that each distance, d, is the same, such that the phase shift boundary 15b occurs at the same distance from any two adjacent edges of opaque areas. In the example of Figure 1, where zones 14a and 14b define a space, each thick zone 14b is centered between opaque lines 12.

Figures 2A - 2C illustrate the effect of the different areas of mask 10 on incident light. As shown in Figure 2A, opaque areas 12 do not transmit any light. The clear zones 14a and 14b, which have two different thicknesses, transmit light to an imaging surface 20, such as a semiconductor wafer-in-process.

Figure 2B shows how the transmitted light has a phase difference because of the different thickness of clear zones 14a and 14b. Light through the thin zone 14a has a zero phase, whereas light through the thick zone 14b has a 180 degree phase shift.

The solid line of Figure 2C illustrates the intensity curve of the transmitted light as received at the imaging surface 20. The dotted line illustrates the intensity curve that would occur if a single, non phase shifting, clear boundary were used. As indicated, the phase shifted curve is steeper than would occur at boundary 15a if boundary 15b were not also present.

Figures 3A - 3H illustrate the process of making a space 14 in a phase shift mask 10 in accordance with the invention. The steps illustrated in Figures 3A - 3C are like those of conventional mask fabrication. However, the steps shown in Figure 3D - 3H include the formation of an etch stop layer 34, thin zones 14a, and thick zones 14b that exhibit the self-alignment feature of the invention.

More specifically, Figure 3A illustrates a mask blank. The mask blank may be any conventional mask blank having two layers, a transparent layer 31 and an opaque layer 32. For purposes of example, transparent layer 31 is glass and opaque layer 32 is chrome.

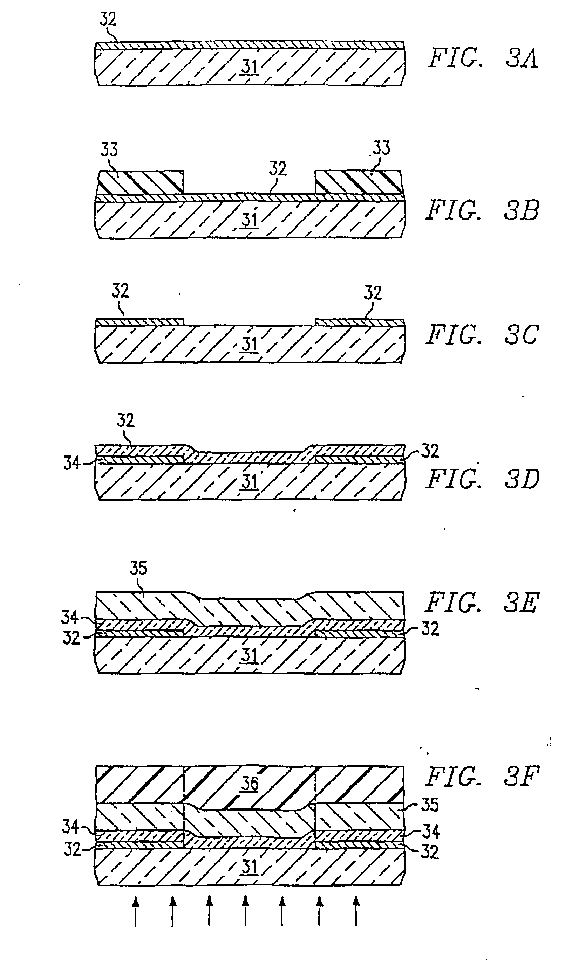

Figure 3B illustrates the mask imaging process, which includes the application of a photoresist layer 33, and its processing to produce images, either optically or by electron beam techniques.

Figure 3C illustrates the resist pattern transfer to the opaque layer 32. Typically, this is accomplished with wet etching. The opaque layer 32 now defines a pattern of opaque areas 12, such as those illustrated in Figures 1 and 2A.

Figure 3D illustrates the deposition of an etch stop layer 34 above the pattern of opaque areas. Etch stop layer 34 may be any light transmitting material. An example of a suitable material is nitride. Typically, etch stop layer 34 is deposited by means of chemical vapor deposition, but could be sputter deposited. For a typical mask 10, etch stop layer 34 might be about 200 angstroms thick. Ideally, etch stop layer 34 has a uniform thickness, which means that it conforms to the irregular surface resulting from the formation of the opaque areas.

As explained below in connection with Figure 3G, etch stop layer 34 resists etching during the formation of the thick zone 14b. It permits controlled etching of a phase shifter layer 35, such that the thin zones 14a are formed.

Figure 3E illustrates the deposition of a phase shifter layer 35 above etch stop layer 34. Like the material used for etch stop layer 34, the material used for phase shift layer 35 is any light transmitting material. However, the material used for phase shift layer 35 does not have the etch resistant characteristic of etch stop layer 34. An example of a suitable material is silicon oxide. Phase shifter layer 35 may be the same material as mask glass 31, such that the controlling factor in determining the phase difference between phase shifter zones 14b and mask glass zones 14a is their relative thickness.

Figure 3F illustrates the deposition of a photoresist layer 36 of negative resist material over phase shifter layer 35. Figure 3F also illustrates the step of exposing the photoresist layer 36 to light incident on the surface of the mask glass 31, thereby making the exposed areas resistant to etching.

Figure 3G illustrates the etching process, whereby the non exposed areas of photoresist layer 36 are removed, as well as areas of shifter layer 35 that are not covered by exposed areas of photoresist layer 36. The etching is a wet etch that is chosen so as to not affect etch stop layer 34.

The etching tends to etch away phase shift layer 35 under the edges of the exposed areas of photoresist layer 36, such when etching is stopped, the remaining areas of phase shift layer 35 are narrower than the overlying exposed areas of resist layer 36. As a result, at every edge of an opaque area, the etching continues laterally outward for some predetermined distance, d. However, downward etching toward mask glass layer 31 is stopped at etch stop layer 34. Etch stop layer 34 remains intact.

Figure 3H illustrates the result of the etching process. Portions of the phase shifting layer 35 remain where overlying areas of exposed resist layer 36 prevented the phase shift material from being etched away. These portions define the thick zones 14b of Figures 1 and 2A. A distance, d, separates the edge of the remaining areas of opaque layer 32 from the edge of the remaining areas of phase shift layer 35. Comparing Figure 3H to Figure 1, this distance, d, defines the thin zones 14a.

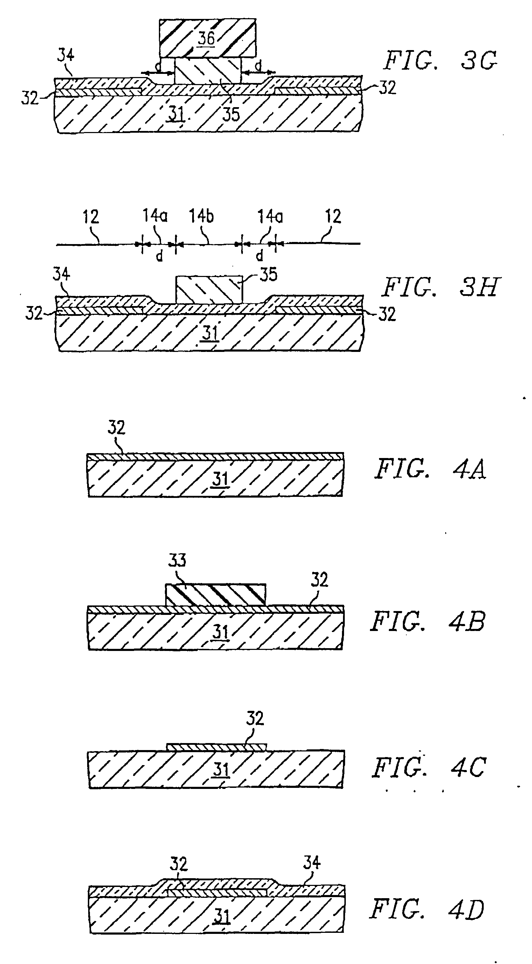

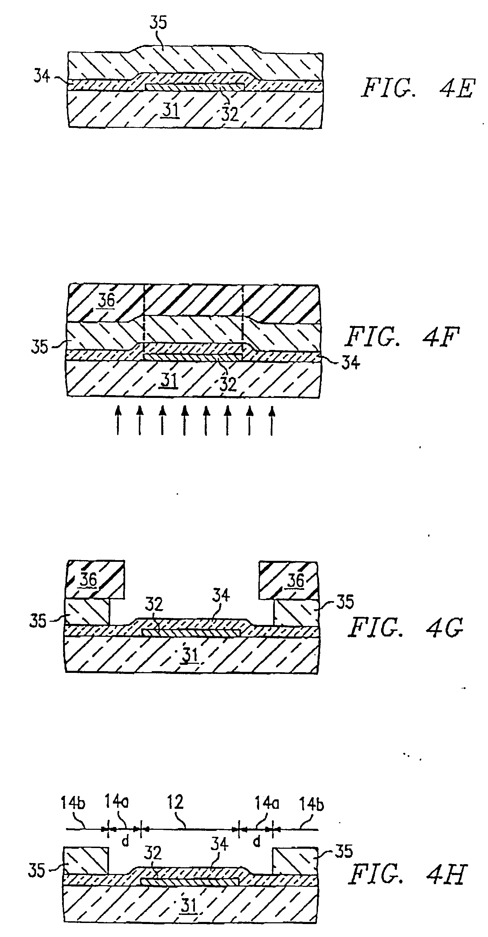

Figures 4A - 4H are similar to Figures 3A - 3H, except that they illustrate the formation of an opaque line 12 rather than a clear space 14. As in Figure 3H, after fabrication, the edges of the opaque areas 12 are defined by a phase shifting boundary 15b. A distance, d, defines a thin zone 14a on either side of the line 12, and d is the same on both sides.

It is clear from the above that an advantage of the invention is that where the opaque areas are to define lines and spaces, or any other feature, the phase shift zones 14a and 14b are self-aligned with respect to the feature edges. The distance, d, that defines the width of the thin zone 14a, i.e., the distance to the phase shifting boundary 15b, is the same on each side of the opaque area 12 or clear space 14. This is an inherent result of the wet etching steps of Figures 3G and 4G.

This self alignment capability becomes more important as features on mask 10 become smaller. If d is not balanced on both sides of the feature, the high contrast boundary will not occur, or will occur only on one side.

Another advantage of the invention is that repairs may be easily made during fabrication of any layer. Defects in the pattern of opaque layer 32 can be repaired before the etch stop layer 34 is deposited. There is no underlying layer that needs to remain undisturbed. The etch stop layer 34 can be repaired by using an etch that will not affect the mask glass 31. Similarly, defects in the phase shift layer 35 can be etched off by using an etch that will not disturb etch stop layer 34.

### Other Embodiments

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A method of making a mask for use in lithographic semiconductor fabrication, which provides phase shift boundaries of the mask features, comprising the steps of:
fabricating a pattern of opaque material on the surface of a mask glass substrate (31), the pattern being comprised of areas (12) of the opaque material (32) separated by clear areas (14) in which the mask glass (31) is not covered by the opaque material (32);
depositing an etch stop layer (34) covering the opaque material (32) and the clear areas (14), the etch stop layer (34) being light transmissive;
fabricating a pattern of phase shift material on the surface of the etch stop layer (34) in areas not covered by the opaque material (32), the phase shift material (35) being spaced from the edges of the opaque areas (12) such that each of the edges is bounded by a thin zone (14a) of the mask glass (31) covered by the etch stop layer (34) and then a thick zone (14b) of the mask glass (31) covered by the etch stop layer (34) and the phase shift material (35); and
wherein fabricating the pattern of phase shift material comprises fabricating by photoresist and wet etching methods, wherein the etching removes areas of the phase shift material (35) not covered by exposed photoresist material (36) and is controlled such that etching is permitted to continue downward along the edges of the opaque areas (12) so as to define the thin zones (14a).

2. The method of claim 1, wherein fabricating the pattern of opaque material comprises fabricating the pattern by conventional photoresist and etching methods.

3. The method of claim 1 or claim 2, further comprising depositing the etch stop layer (34) with a chemical vapor deposition process.

4. The method of any of claims 1 to 3, further comprising depositing the phase shift material (35) to a thickness calculated to result in transmitted light with a 180 degree phase difference from light transmitted through the mask glass (31).

## Patentansprüche

1. Verfahren zum Fertigen einer Maske zur Verwendung bei der lithographischen Halbleiterherstellung, das Phasenverschiebungsgrenzen der Maskenstrukturen ergibt, mit den Schritten:
Herstellen eines Musters aus lichtundurchlässigem Material auf der Oberfläche eines Maskenglassubstrats (31), wobei das Muster aus Bereichen (12) des lichtundurchlässigen Materials (32) besteht, die durch klare Bereiche (14) getrennt sind, in denen das Maskenglas (31) nicht von dem lichtundurchlässigen Material (32) bedeckt ist,
Aufbringen einer Ätzstoppschicht (34), die das lichtundurchlässige Material (32) und die klaren Bereiche (14) bedeckt, wobei die Ätzstoppschicht (34) lichtdurchlässig ist,
Herstellen eines Musters aus Phasenverschiebungsmaterial auf der Oberfläche der Ätzstoppschicht (34) in Bereichen, die nicht von dem lichtundurchlässigen Material (32) bedeckt sind, wobei das Phasenverschiebungsmaterial (35) derart in einem Abstand von den Rändern der lichtundurchlässigen Bereiche (12) angeordnet wird, daß jeder der Ränder von einer dünnen Zone (14a) aus dem Maskenglas (31), die von der Ätzstoppschicht (34) bedeckt ist, und dann von einer dicken Zone (14b) aus dem Maskenglas (31), die von der Ätzstoppschicht (34) und dem Phasenverschiebungsmaterial (35) bedeckt ist, begrenzt wird, und
wobei das Herstellen des Musters aus Phasenverschiebungsmaterial ein Herstellen durch Photoresist- und Naßätzverfahren beinhaltet, wobei durch das Ätzen Bereiche des Phasenverschiebungsmaterials (35) entfernt werden, die nicht von belichtetem Photoresistmaterial (36) bedeckt sind, und wobei es belichtetem Photoresistmaterial (36) bedeckt sind, und wobei es so gesteuert wird, daß das Fortsetzen des Ätzens nach unten entlang den Rändern der lichtundurchlässigen Bereiche (12) ermöglicht wird, um die dünnen Zonen (14a) auszubilden.

2. Verfahren nach Anspruch 1, wobei das Herstellen des Musters aus lichtundurchlässigem Material das Herstellen des Musters durch herkömmliche Photoresist- und Ätzverfahren beinhaltet.

3. Verfahren nach Anspruch 1 oder 2, welches weiter das Aufbringen der Ätzstoppschicht (34) durch einen chemischen Dampfabscheidungsprozeß beinhaltet.

4. Verfahren nach einem der Ansprüche 1 bis 3, welches weiter das Aufbringen des Phasenverschiebungsmaterials (35) bis zu einer Dicke, die so berechnet ist, daß sie zu durchgelassenem Licht führt, das eine Phasendifferenz von 180 Grad gegenüber von dem Maskenglas (31) durchgelassenem Licht aufweist, beinhaltet.

## Revendications

1. Procédé de fabrication d'un masque destiné à être utilisé lors d'une fabrication lithographique de semiconducteur, qui fournit des limites de déphasage des éléments du masque, comprenant les étapes de :
fabrication d'une configuration de matériau opaque sur la surface d'un substrat (31) de masque en verre, la configuration étant constituée de zones (12) du matériau opaque (32) séparées par des zones claires (14) dans lesquelles le verre de masque (31) n'est pas recouvert par le matériau opaque (32) ;
dépôt d'une couche (34) d'arrêt de gravure recouvrant le matériau opaque (32) et les zones claires (14), la couche (34) d'arrêt de gravure étant capable de transmettre la lumière ;
fabrication d'une configuration de matériau de déphasage sur la surface de la couche (34) d'arrêt de gravure, dans des zones non recouvertes par le matériau opaque (32), le matériau (35) de déphasage étant espacé des bords des zones opaques (12) de telle sorte que chacun des bords est limité par une zone mince (14a) du verre de masque (31) recouverte par la couche (34) d'arrêt de gravure et ensuite par une zone épaisse (14b) du verre de masque (31) recouverte par la couche (34) d'arrêt de gravure et le matériau de déphasage (35) ; et
dans lequel la fabrication de la configuration du matériau de déphasage comprend la fabrication par des procédés de photorésist et de gravure humide, la photogravure éliminant des zones du matériau (35) de déphasage non recouvertes par un matériau de photorésist exposé (36), et est commandée de telle sorte que la gravure peut se poursuivre vers le bas le long des bords des zones opaques (12), de manière à définir les zones minces (14a).

2. Procédé selon la revendication 1, dans lequel la fabrication de la configuration de matériau opaque comprend la fabrication de la configuration par des procédés conventionnels de photorésist et de gravure.

3. Procédé selon la revendication 1 ou la revendication 2, comprenant en outre le dépôt de la couche (34) d'arrêt de gravure avec un processus de dépôt chimique en phase vapeur.

4. Procédé selon l'une quelconque des revendications 1 à 3, comprenant en outre le dépôt du matériau de déphasage (35) sur une épaisseur calculée pour conduire à une lumière transmise avec une différence de phase de 180 degrés par rapport à la lumière transmise par l'intermédiaire du verre de masque (31).
